# EUROPÄISCHE PATENTSCHRIFT

(11) **EP 0 614 271 B1**
(45) Veröffentlichungstag und Bekanntmachung des Hinweises auf die Patenterteilung: **01.10.1997**
(21) Anmeldenummer: 94890032.9
(22) Anmeldetag: 07.02.1994
(51) Int. Cl.: H03H 9/02, H03H 9/17

(54) **Piezoelektrisches Kristallelement**
Piezoelectric crystal element
Cristal piézoélectrique

(30) Priorität: 04.03.1993 AT 422/93
(43) Veröffentlichungstag der Anmeldung: 07.09.1994
(73) Patentinhaber: AVL List GmbH, 8020 Graz (AT)
(72) Erfinder: Wallnöfer, Wolfgang, A-8045 Graz (AT); Krempl, Peter W., Dr., A-8047 Graz/Ragnitz (AT)
(74) Vertreter: Krause, Walter, Dr. Dipl.-Ing.

(56) Entgegenhaltungen:
- EP-A- 0 370 996
- SENSORS AND ACTUATORS A, Bd.30, 1992, LAUSANNE CH Seiten 73 - 75, XP277698 F.MÖLLER ET AL 'SAW RESONATOR TEMPERATURE SENSOR'

## Beschreibung

Die Erfindung betrifft ein piezoelektrisches Kristallelement mit zumindest einer im wesentlichen ebenen Fläche, für akustische Oberflächenwellenanwendungen.

Akustische Oberflächenwellen (AOW) auf Piezoelektrika werden in zahlreichen Bauelementen zur Signalverarbeitung verwendet. Diese Anwendungen im VHF- und UHF-Bereich umfassen Filter, Oszillatoren, Verzögerungsleitungen, Konvolver und verschiedene Arten von Sensoren. Die wichtigsten, vom jeweils verwendeten Substrat abhängigen Gütekriterien für AOW-Bauelemente sind Temperaturstabilität der Laufzeit bzw. der Mittenfrequenz, niedrige Einfügedämpfung (Abschwächung eines Signals durch Einbau eines Bauelementes in den Signalweg), sowie hohe Bandbreite. Die beiden letzteren Kriterien lassen sich nur durch hohe piezoelektrische Kopplung gemeinsam erfüllen. Der Temperaturkoeffizient der Laufzeit ergibt sich aus der Differenz der Temperaturkoeffizienten von Wellengeschwindigkeit und Weglänge. Heben sich beide auf, spricht man von einem temperaturkompensierten Schnitt. Derartige Schnitte sind jedoch nur bei wenigen Materialien realisierbar.

Als Substratmaterialen werden hauptsächlich ST-Quarz und Lithiumniobat verwendet. Ersteres bietet hohe Temperaturstabilität, jedoch nur schwache piezoelektrische Kopplung. Lithiumniobat hingegen hat eine sehr hohe Kopplung, die Laufzeit steigt jedoch mit der Temperatur stark an. Als Kompromißlösung zwischen beiden Forderungen wurde auch Lithiumtantalat verwendet, die Temperaturstabilität ist jedoch auch hier für viele Anwendungen zu gering.

Die Suche nach Materialien, die eine hohe piezoelektrische Kopplung und eine ausreichende Temperaturstabilität verbinden, ergab als interessanteste Materialien Berlinit (AlPO₄) und Lithiumtetraborat (Li₂B₄O₇). Beide Materialien haben eine höhere Kopplung als Quarz und weisen jeweils Schnitte mit verschwindendem ersten Temperaturkoeffizienten der Laufzeit auf. Der zweite (quadratische) Temperaturkoeffizient ist jedoch jeweils um mehr als eine Größenordnung höher als beim ST-Quarz. Beide Substrate haben sich daher kaum durchgesetzt.

Beispielsweise wird in der US-PS 4 109 172 ein temperaturkompensierter Berlinit-Wafer als Oberflächenwellenelement vorgeschlagen, dessen Oberfläche durch die Eulerwinkel λ = 0°, µ = 80,4° und θ = 0° bestimmt ist. Weiters ist aus der EP 0 144 544 B1 eine temperaturkompensierte Ausrichtung eines Berlinit-Kristalls bekannt, dessen ebene Fläche durch die Winkel nach Euler λ = 0°, µ ca. 94° bis 104° und θ = 0° bestimmt ist.

Die bisherigen Ausführungen beziehen sich auf den Standardtemperaturbereich für militärische bzw. kommerzielle Anwendungen. Noch stärker ist der Mangel an geeigneten Substratmaterialien im Hochtemperaturbereich von 100 bis 900°C ausgeprägt, da sich die Temperaturstabilität von Quarz und Berlinit bei höheren Temperturen extrem verschlechtert. Der α-β-Phasenübergang bei 573°C bzw. 588°C bildet die oberste Grenze für ihre Verwendbarkeit. Dieser Bereich wäre jedoch für Sensoranordnungen von Interesse, da einerseits manche Anwendungsgebiete in diesen Temperaturbereichen liegen und andererseits die Ansprechzeit von chemischen Sensoren auf AOW-Basis mit der Temperatur stark abnimmt.

Wie bereits in der EP-A 0 069 112 beschrieben, weisen andere Kristalle der Punktsymmetrieklasse 32 mit der chemischen Summenformel ABO₄ eine wesentlich bessere Temperaturbeständigkeit bezüglich wichtiger physikalischer Eignschaften auf. Z. B. zeigt die Tiefentemperaturform von Galliumorthophosphat (GaPO₄) die zum Quarz homöotyp und zu Berlinit isotyp ist, im Gegensatz zu diesen keinen α-β-Phasenübergang, sondern ist bis 930°C stabil. Eine temperaturkompensierte Orientierung für Resonatoren mit höherer piezoelektrischer Kopplung als bei Quarz ist beispielsweise in der AT-PS 390 853 beschrieben. Allerdings sind diese Orientierungen nicht für AOW-Anwendungen geeignet.

Aufgabe der Erfindung ist es nun, piezoelektrische Kristallelemente für akustische Oberflächenwellenanwendungen vorzuschlagen, welche in ihrer Temperaturstabilität bisherige Materialien übertreffen und diese Temperaturstabilität möglichst auch bei hohen Temperaturen beibehaten.

Diese Aufgabe wird erfindungsgemäß dadurch gelöst, daß das Kristallelement aus GaPO₄ besteht und die ebene Fläche durch die Eulerwinkel λ von im wesentlichen 0°, µ im Bereich von 40° bis 75°, vorzugsweise 50° bis 60°, und θ von im wesentlichen 0° bestimmt ist. Der optimale, temperaturkompensierte Schnittwinkelbereich für AOW-Anwedungen für GaPO₄-Kristalle liegt überraschenderweise deutlich außerhalb des Bereiches, der für das ähnlichste, in diesem Zusammenhang untersuchte Material, Berlinit, angegeben wird (Eulerwinkel µ = 80° bis 104°). Die Toleranzen für die Eulerwinkel λ und θ betragen in etwa ± 5°.

Als weiterer Vorteil des erfindungsgemäßen Kristallelementes sei hervorgestrichen, daß das Produkt aus Periodenlänge der Interdigitalwandler und Mittenfrequenz der Oberflächenwellenanordnung zwischen 2250 und 2400 µm MHz liegt. Dieses Produkt ist deutlich niedriger als bei Quarz und Berlinit und ermöglicht daher bei derselben Mittenfrequenz eine kompaktere und weniger Material benötigende Bauweise.

Zumindest eine Oberfläche des Kristallelementes, auf welcher die elektronische Schaltung, beispielsweise die Interdigitalwandler aufgebracht sind, ist glatt poliert ausgeführt, während die andere Oberfläche weniger kritisch ist und unter Umständen auch zur Minderung des Einflusses der Volumswellenreflexion aufgerauht oder nicht ganz parallel zur anderen Oberfläche ausgeführt sein kann. Insbesondere ist es auch möglich, daß das Kristallelement im wesentlichen die Form eines Wafers aufweist. Dicke und Umriß des Wafers sind dabei nicht kritisch.

In einer weiteren Ausgestaltung der Erfindung ist vorgesehen, daß das Kristallelement Bestandteil eines chemischen Sensors ist und ganz oder teilweise mit einer sensitiven Schicht sowie ggf. mit einer Referenzschicht bedeckt ist. Dabei kann die sensitive Schicht bis 900°C temperaturbeständig sein und daher problemlos ausgeheizt werden.

Die Erfindung wird im folgenden anhand von Zeichnungen näher erläutert.
- Fig. 1: die Lage eines erfindungsgemäßen piezoelektrischen Kristallelementes in einem GaPO₄-Kristall,
- Fig. 2: ein erfindungsgemäßes Kristallelement mit einem akustischen Oberflächenwellen-Filter und
- Fig. 3: in schematischer Darstellung einen chemischen Sensor auf der Basis eines piezoelektrischen Kristallelementes nach Fig. 2.

Die Orientierung des piezoelektrischen Kristallelementes 1 in einem GaPO₄-Kristall 2 wird durch die drei Eulerwinkel λ, µ und θ definiert. Diese bezeichnen die Winkel, um die ein Koordinatensystem x', y', z' dessen Achsen zuvor mit den drei Kristallachsen X, Y und Z übereinstimmen, nacheinander um seine dritte, erste und dritte Achse gedreht wird. Dabei bestimmt die erste Achse x' des gedrehten Systems die Richtung der Phasengeschwindigkeit der AOW und die dritte Achse z' die Normale auf die Oberfläche 3 des Kristallelementes 1. Bei sogenannten X-Boule-Schnitten, wozu auch die erfindungsgemäßen Schnitte gehören, stimmt die Phasengeschwindigkeitsrichtung wegen λ = θ = 0° mit der x'-Achse überein. Da diese bei GaPO₄ eine zweizählige kristallographische Symmetrieachse ist, liegt auch die Gruppengeschwindigkeit in x'-Richtung und ihr Betrag weist dort einen Extremwert auf. Dies hat zwei günstige Eigenschaften zur Folge: Erstens kommt es zu keinem Strahlschräglauf (beam steering) und zweitens zu einer geringen Empfindlichkeit auf Fehlorientierung bezüglich θ.

Die Tatsache, daß es sich hier um einfach gedrehte Schnitte handelt, erleichtert das Orientieren und Schneiden des Kristallelementes wesentlich, besonders im Fall einer Massenproduktion.

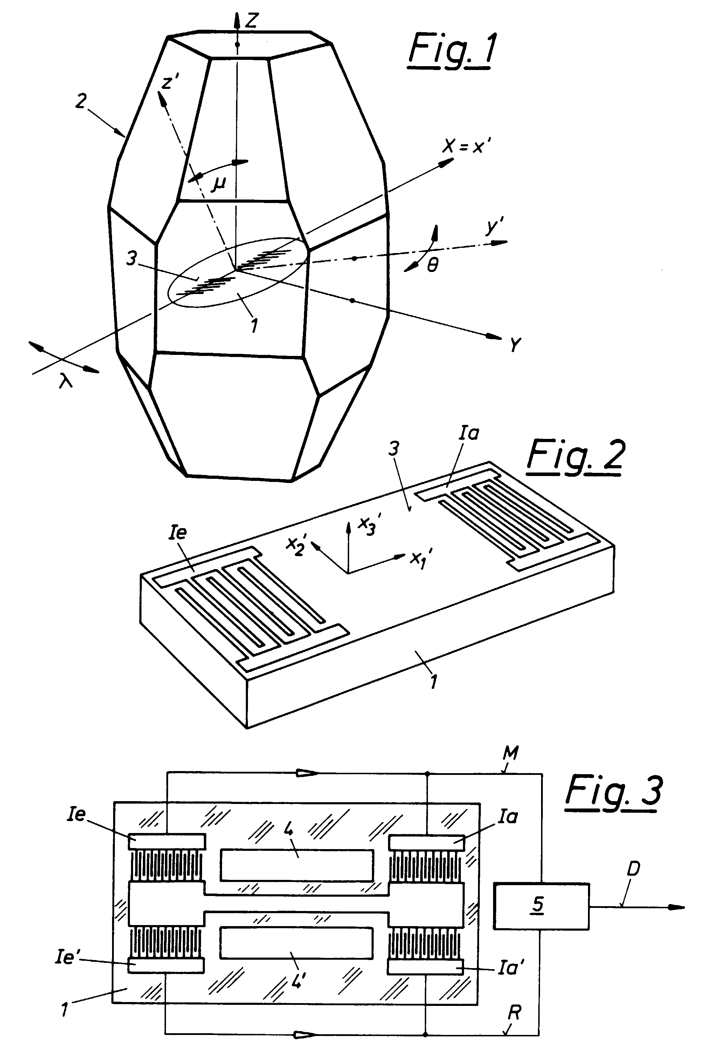

Die Erfindung kann hauptsächlich im Frequenzbereich von 30 MHz bis 3 GHz für zahlreiche elektronische Anwendungen eingesetzt werden. Ein einfaches Beispiel ist ein Transversalfilter (Fig. 2). Dabei werden zwei Interdigitalwandler Ie, Ia auf die ebene Fläche 3 des piezoelektrischen Kristallelementes 1 aufgebracht. Ein elektrisches Signal am Eingangswandler Ie regt über die piezoelektrische Kopplung eine akustische Oberflächenwelle im Substrat an. Diese bewegt sich entlang der Oberfläche 3 zum Ausgangswandler Ia und erzeugt dort das elektrische Ausgangssignal. Durch Variation des Wandlers kann das Durchlaßverhalten des Filters optimiert werden.

Eine andere mögliche Ausführung der Erfindung ist ein chemischer Sensor auf AOW-Basis. Eine solche Anordnung ist z.B. in Fig. 3 skizziert. Dabei ist die Fläche zwischen oder im Bereich der Wandler Ia, Ie mit einer selektiv absorbierenden Schicht 4 bedeckt. Die Meßfrequenz M und die von einer Referenzanordnung (Wandler Ie', Ia' und Referenzschicht 4') stammende Referenzfrequenz R werden einer Signalverarbeitung 5 zugeführt, wo eine Differenzfrequenz D als eigentliches Meßsignal gewonnen wird. Durch die absorptionsbedingte Massenbeladung der Oberfläche ändert sich die Phasenverschiebung zwischen ein- und austretendem Signal. Mit einer Oszillatorschaltung kann damit die Konzentration, z.B. von Gasen, gemessen werden. Durch die hohe Temperaturstabilität von GaPO₄ kann ein solcher Sensor auf diesem Substrat bei Temperaturen bis 900°C betrieben oder ausgeheizt werden.

Zur Verringerung von Wellendämpfung und Parameterschwankungen ist es von Vorteil, zonenreines Kristallmaterial, vorzugsweise aus der Wachstumszone der (0001)-Fläche des Rohkristallbarrens 2 zu verwenden. Außerdem sollte die Infrarotabsorption im Wellenlängenbereich von 3 µm, die ein Maß für die Konzentration der OH-Störstellen darstellt, möglichst gering sein.

In Abhängigkeit vom Temperaturbereich ist der Winkel µ innerhalb des beanspruchten Bereiches so zu wählen, daß die Temperaturabhängigkeit der Laufzeit bzw. der Mittenfrequenz möglichst gering ist. Die wichtigsten Bereiche sind die Normalbereiche für industrielle (20° bis 85°C) und militärische (-55°C bis 125°C) Spezifikationen sowie weitere Bereiche bis zu hohen Temperaturen für Sensoranwendungen, z.B. 20°C bis 900°C. Vorzugsweise ist hier so vorzugehen, daß die Differenz zwischen maximalem und minimalem Wert der Laufzeit im interessierenden Temperaturbereich beim gewählten Winkel minimal ist.

## Patentansprüche

1. Piezoelektrisches Kristallelement mit zumindest einer im wesentlichen ebenen Fläche, für akustische Oberflächenwellenanwendungen, **dadurch gekennzeichnet,** daß das Kristallelement (1) aus GaPO₄ besteht und die ebene Fläche (3) durch die Eulerwinkel λ von im wesentlichen 0°, µ im Bereich von 40° bis 75°, vorzugsweise 50° bis 60°, und θ von im wesentlichen 0° bestimmt ist.

2. Kristallelement nach Anspruch 1, mit Interdigitalwandlern, **dadurch gekennzeichnet,** daß das Produkt aus Periodenlänge der Interdigitalwandler (Ia, Ie) und Mittenfrequenz der Oberflächenwellenanordnung zwischen 2250 und 2400 µm MHz liegt.

3. Kristallelement nach Anspruch 1 oder 2, **dadurch gekennzeichnet,** daß das Kristallelement (1) im wesentlichen die Form eines Wafers aufweist.

4. Kristallelement nach einem der Ansprüche 1 bis 3, **dadurch gekennzeichnet,** daß das Kristallelement (1) Bestandteil eines chemischen Sensors ist und ganz oder teilweise mit einer sensitiven Schicht (4) sowie ggf. mit einr Referenzschicht (4') bedeckt ist.

5. Kristallelement nach Anspruch 4, **dadurch gekennzeichnet,** daß die sensitive Schicht (4) bis 900 °C temperaturbeständig ist.

## Claims

1. Piezoelectric crystal element with at least one substantially planar surface, to be used in surface acoustic wave devices, **characterized in that** the crystal element (1) is made from GaPO₄ and the planar surface (3) is defined by Euler angles lambda of 0° substantially, µ in the range of 40° to 75°, i.e., preferably 50' to 60°, and θ of 0° substantially.

2. Crystal element as in claim 1, with interdigital transducers, **characterized in that** the product of period length of the interdigital transducers (Ia, Ie) and center frequency of the surface acoustic wave device is between 2,250 and 2,400 µm MHz.

3. Crystal element as in claim 1 or 2, **characterized in that** the crystal element (1) is substantially configured as a wafer.

4. Crystal element as in any of claims 1 to 3, **characterized in that** the crystal element (1) is part of a chemical sensor and is covered entirely or partially by a sensitive layer (4) and, if required, by a reference layer (4').

5. Crystal element as in claim 4, **characterized in that** the sensitive layer (4) is heat resistant up to 900°C.

## Revendications

1. Elément cristallin piézoélectrique, comportant au moins une surface sensiblement plane, pour des applications acoustiques d'ondes de surface, caractérisé en ce que l'élément cristallin (1) est constitué de GaPO₄ et la surface plane (3) est déterminée par le fait que l'angle d'Euler λ est de sensiblement 0°, µ est situé dans la plage allant de 40° à 75°, de préférence de 50° à 60°, et θ est de sensiblement 0°.

2. Elément cristallin selon la revendication 1, avec des convertisseurs internumériques, caractérisé en ce que le produit composé à partir de la longueur de la période des convertisseurs internumériques (Ia, Ie) et la fréquence moyenne du dispositif à ondes de surface est située dans la plage comprise entre 2250 et 2400 µm MHz.

3. Elément cristallin selon la revendication 1 ou 2, caractérisé en ce que l'élément cristallin (1) présente sensiblement la forme d'une plaquette de semi-conducteur.

4. Elément cristallin selon l'une des revendications 1 à 3, caractérisé en ce que l'élément cristallin (1) fait partie d'un capteur chimique et est recouvert en totalité ou en partie d'une couche (4) sensible ainsi que, le cas échéant, d'une couche de référence (4').

5. Elément cristallin selon la revendication 4, caractérisé en ce que la couche sensible (4) est résistante à la température, jusqu'à une valeur de 900 °C.
